Europäisches Patentamt

European Patent Office

Office européen des brevets

(19)

(11) **EP 0 549 591 B1**

(12) **EUROPEAN PATENT SPECIFICATION**

(45) Date of publication and mention
of the grant of the patent:
**07.01.1998 Bulletin 1998/02**

(21) Application number: **91913634.1**

(22) Date of filing: **09.07.1991**

(51) Int Cl.$^6$: **H04J 3/02**

(86) International application number:
**PCT/SE91/00487**

(87) International publication number:
**WO 92/01344 (23.01.1992 Gazette 1992/03)**

(54) **PHASE LOCKING CIRCUIT FOR JITTER REDUCTION IN A DIGITAL MULTIPLEX SYSTEM**

PHASENVERRIEGELUNGSANORDNUNG FÜR JITTERREDUZIERUNG IN EINEM DIGITALEN MULTIPLEXSYSTEM

CIRCUIT A VERROUILLAGE DE PHASE REDUISANT LE SAUTILLEMENT DANS UN SYSTEME MULTIPLEXEUR NUMERIQUE

(84) Designated Contracting States:
**BE CH DE DK ES FR GB GR IT LI NL**

(30) Priority: **10.07.1990 SE 9002408**

(43) Date of publication of application:
**07.07.1993 Bulletin 1993/27**

(73) Proprietor: **TELEFONAKTIEBOLAGET L M
ERICSSON
126 25 Stockholm (SE)**

(72) Inventor: **BLADH, Mats
S-146 00 Tullinge (SE)**

(74) Representative: **Delhage, Einar et al
Bergenstrahle & Lindvall AB
Box 17704
118 93 Stockholm (SE)**

(56) References cited:
**EP-A- 0 100 077          EP-A- 0 197 492
EP-A- 0 266 588          DE-A- 2 931 401
FR-A- 2 593 337          US-A- 3 420 956
US-A- 3 830 981          US-A- 3 920 915
US-A- 4 393 279          US-A- 4 397 017
US-A- 4 730 347          US-A- 4 825 437**

## Description

The present invention relates to a phase locking circuit for jitter reduction in a multiplex system.

In a digital multiplexer of the digital cross connect (DCC) type, a phase locked circuit or loop (PLL) shall lock on to frequency differences, which requires "large" gain and "large" bandwidth. When the system has been phase locked, the output signal shall have low inherent jitter, in accordance with standards for acceptable jitter level, which requires "low" gain due to digitally generated jitter in the multiplex system.

Solutions up to now have comprised the manipulation of gain and bandwidth, with accompanying problems, either with jitter or locking.

Earlier solutions, as disclosed in for example US patents 4,397,017, 3,830,981, 3,420,956 solve the problem by inserting "stuffing" pulses that carry no information and are only used for the purpose of reduce jitter.

Circuits for reducing jitter when extracting a base clock signal directly from an arriving digital pulse train are for example disclosed in US patents 4,704,722 and 4,129,748.

The object of the present invention is to provide a solution to the problem of inherent jitter contra phase locking in a digital multiplexer of the DCC type in a simple, cheap, space and current saving way.

This object is achieved with a circuit of the kind described in the introduction, including the features stated in claim 1 or 5.

Thus a feed-back operational amplifier is provided having two inputs. Two anti-parallel coupled diodes are arranged at one input of the operational amplifier for achieving automatic gain control and the other input of the operational amplifier is connected to a reference voltage.

The operational amplifier is preferably of FET or CMOS type having a high-ohm amplifier input, so that the load from the amplifier will be low.

With the circuit according to the invention low gain in a locked circuit is thus obtained in a very simple way, resulting in low inherent jitter, and at the same time high gain for a circuit that has not been locked, or has a high input jitter.

According to one embodiment of the circuit according to the invention, an RC circuit is arranged before the diodes on the amplifier input for letting through frequency and phase differences, for the purpose of filtering, but for attenuating the input frequencies and input signals to the phase comparator.

According to another advantageous embodiment of the circuit according to the invention, a series resistance is provided on the amplifier input for dimensioning purposes. This resistance is intended to limit the magnitude of the gain for an unlocked circuit, and in principle it could be included in the resistance of the above-mentioned RC circuit. However, in arranging this gain regulation resistance separately the adjustment of the gain is facilitated.

According to a further advantageous embodiment of the circuit according to the invention, the reference voltage for the amplifier is selected such that the operation will take place substantially in the central part of a buffer store.

Thus generally, the phase locking circuit is used in a digital multiplex system having a buffer store. An incoming bitstream arrives to the buffer store and an output bitstream is forwarded from the buffer store. The output bitstream frequency is controlled by the phase locking circuit. This circuit comprises a phase comparator, a voltage controlled oscillator and a control circuit. The buffer store has control signal outputs, on which signals are generated indicating the phase of the pulses in the incoming bitstream and the phase of the pulses forwarded from the buffer store. The phase comparator is connected to receive the control signals in order to deliver an output signal representative of the mutual phase position of the pulses in the incoming and the forwarded bitstream. This output signal is fed to the control circuit for automatic gain control, so that the control circuit controls the pulse rate of the voltage controlled oscillator, which generates clock pulses for clocking the pulses of the forwarded bitstream. The control circuit then comprises a feed-back operational amplifier, that is coupled between the phase comparator and the voltage controlled oscillator. The operational amplifier has an output and first and second high-ohmic inputs. The first input receives feedback from the output and the second input is coupled to a reference voltage. Two diodes are coupled anti-parallel to each other at the first input of the operational amplifier for achieving the automatic gain control.

An embodiment of the circuit according to the invention, selected as an example, will now be described in more detail with reference to the accompanying drawing, on which:

Figure 1 illustrates the location of the circuit in a practical application, and
Figure 2 is a circuit diagram of the circuit.

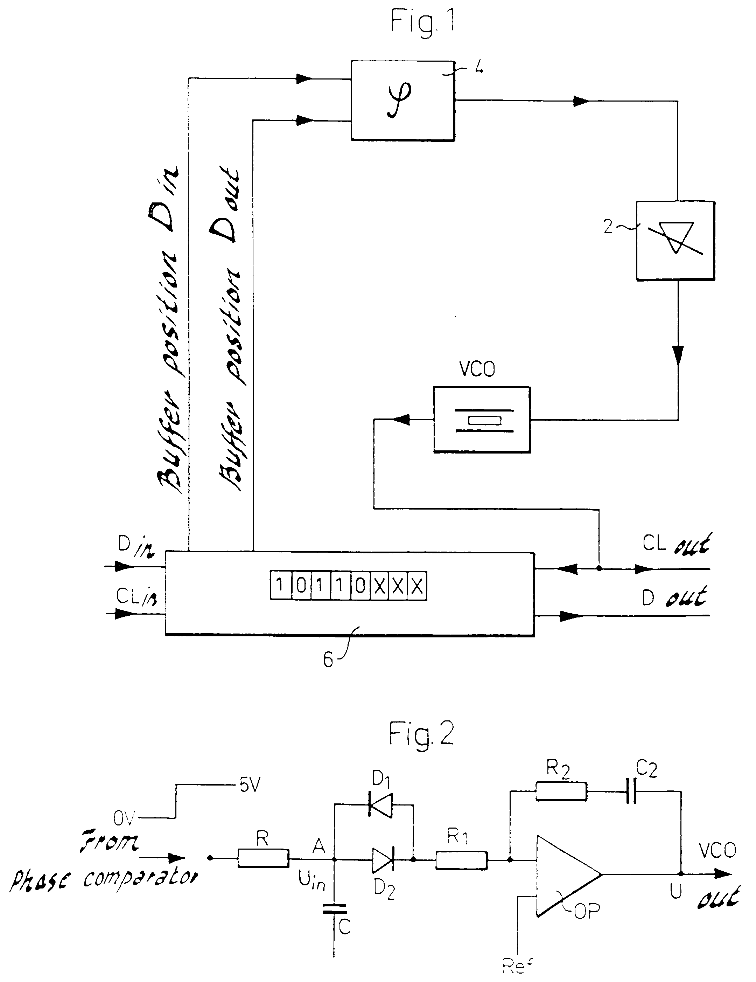

The circuit 2 in accordance with the invention is connected between a phase comparator 4 and a voltage controlled oscillator VCO with associated buffer store 6, as illustrated in Figure 1. $D_{in}$ and $Cl_{in}$ respectively denote data and clock inputs, and $D_{out}$ and $Cl_{out}$ respectively denote outputs for data and clock signals.

The circuit in accordance with the invention includes an operational amplifier OP, which is fed back by the loop $R_2$, $C_2$, as will be seen from Figure 2. $R_2$ is a high-ohm resistance, and the capacitor $C_2$ is dimensioned to give a long time constant (DC separation).

One input on the amplifier OP is connected to the phase comparator 4 via an RC circuit, which is adapted to pass frequency differences and block fundamental frequencies to the phase comparator. There is thus obtained at the point A substantially the phase and frequency difference from the phase comparator and only a low superposed AC level.

Two diodes $D_1$ and $D_2$ coupled in anti-parallel are connected in series with a resistance $R_1$ between the point A and the input of the amplifier OP. Desired automatic gain control is thus produced in a very simple way.

The gain F will substantially be

$$F = \frac{R_2}{R_1 + R_{D12}}$$

where $R_{D12}$ denotes a mean value of the resistance through the diodes.

For a locked PLL circuit the output voltage $U_{out}$ of the amplifier OP is constant, and a small current flows through the diodes $D_1$ and $D_2$, which then will be high-ohmic, the gain F decreasing and the jitter being attenuated. For an unlocked PLL circuit, a larger current passes through the diodes $D_1$ and $D_2$, which then become low-ohmic, and the gain increases, so that the phase and frequency differences can be captured. There is thus obtained in a simple way the desired automatic gain control with a smooth transition between the two states, and which thus switches to low-ohm state between high- and low-ohm states in response to variations in the input voltage $U_{in}$.

The circuit according to the invention includes two diodes $D_1$ and $D_2$ coupled in anti-parallel to be able to operate in both directions. The diodes are suitably ordinary silicon diodes.

The resistance $R_1$ is selected so that the gain F will be of a suitable magnitude in the case when the diodes $D_1$ and $D_2$ are low-ohmic, i.e. when $R_{D12}$ is approximately equal to zero. In principle, $R_1$ could be included in the resistance R, but the adjustment of the gain F is facilitated by the arrangement of a separate resistance $R_1$ for this purpose. The operational amplifier OP is suitably of the FET or CMOS type, with a high-ohm amplifier input, such that it conducts as small a current as possible through the diodes, thus making them high-ohmic.

As illustrated in the figure, the circuit may suitably operate at signal levels of 5 V, it then being suitable to choose the reference voltage Ref. to the operational amplifier OP equal to 2.5 V, which will mean that operation will be substantially in the middle of the buffer store 6, cf. Figure 1.

## Claims

1. A phase locking circuit for jitter reduction in a digital multiplex system, the circuit comprising a feed-back operational amplifier (OP) having two inputs, two anti-parallel coupled diodes ($D_1$, $D_2$) being arranged at one input of the operational amplifier (OP) for achieving automatic gain control, the other input of the operational amplifier being connected to a reference voltage (Ref.), the operational amplifier (OP) being the FET or CMOS type, having high-ohmic amplifier inputs.

2. A phase locking circuit as claimed in claim 1, further comprising an RC-circuit (R, C) connected before the diodes ($D_1$, $D_2$) that are connected to the one input of the operational amplifier (OP) for only letting through phase and frequency differences for filtering purposes.

3. A phase locking circuit as claimed in claim 1 or 2, further comprising a series resistance ($R_1$) connected to the one input of the operational amplifier (OP) for dimensioning purposes.

4. A phase locking circuit as claimed in any one of claims 1 - 3, wherein the reference voltage (Ref.) for the operational amplifier (OP) is selected such that operation will be substantially in the middle of a buffer store (6).

5. A phase locking circuit for jitter reduction by controlling the output bitstream ($D_{out}$) frequency in a digital multiplex system of the kind having a buffer store (6), an incoming bitstream ($D_{in}$) arriving to the buffer store (6) and an output bitstream ($D_{out}$) being forwarded from the buffer, the buffer store (6) having control signal outputs, on which signals (Buffer position $D_{in}$, Buffer position $D_{out}$) are generated indicating the phase of the pulses in the incoming bitstream ($D_{in}$) and the phase of the pulses ($D_{out}$) forwarded from the buffer store (6), the phase locking circuit comprising

    a phase comparator (4),
    a voltage controlled oscillator (VCO) and
    a control circuit (2),
    the phase comparator (4) being connected to receive said control signals to deliver an output signal representative of the mutual phase position of the pulses in the incoming and the forwarded bitstream ($D_{in}$, $D_{out}$), the output signal being fed to said control circuit (2) for automatic gain control, the control circuit (2) controlling the pulse rate of the voltage controlled oscillator (VCO), which generates clock pulses for clocking the pulses of the forwarded bitstream ($D_{out}$), and
    the control circuit comprising

    - a feed-back operational amplifier (OP), coupled between the phase comparator (2) and the voltage controlled oscillator (VCO), the operational amplifier (OP) having an output and first and second inputs, the inputs being high-ohmic, the first input receiving feedback ($R_2$, $C_2$) from the output and the second input being coupled to a reference voltage (Ref.), and

- two diodes coupled anti-parallel to each other at the first input of the operational amplifier (OP) for achieving said automatic gain control.

6. A phase locking circuit in a digital multiplex system as claimed in claim 5, wherein the control circuit (2) further comprises an RC-circuit (R, C) coupled to an input for the two diodes ($D_1$, $D_2$) for only letting through phase and frequency differences detected by the phase comparator (4), and for filtering purposes.

7. A phase locking circuit in a digital multiplex system as claimed in claim 6, wherein the control circuit (2) further comprises a further series resistance ($R_1$) coupled between the two diodes ($D_1$, $D_2$) and the first input of the operational amplifier (OP) for dimensioning purposes.

8. A phase locking circuit in a digital multiplex system as claimed in any one of claims 5 - 7, wherein the operational amplifier (OP) in the control circuit (2) is the FET or CMOS type, having high-ohmic amplifier inputs.

9. A phase locking circuit in a digital multiplex system as claimed in any one of claims 5 - 8, wherein the reference voltage (Ref.) for the operational amplifier (OP) is related to the operation of the buffer store (6).

**Patentansprüche**

1. Phasenregelschaltung zur Jitterverringerung in einem digitalen Multiplexsystem, wobei die Schaltung umfaßt: einen rückgekoppelten Operationsverstärker (OP) mit zwei Eingängen, zwei antiparallel geschaltete Dioden ($D_1$, $D_2$), die an einem Eingang des Operationsverstärkers (OP) zum Erzielen einer automatischen Verstärkungssteuerung angeordnet sind, wobei der andere Eingang des Operationsverstärkers mit einer Referenzspannung (Ref.) verbunden ist, und der Operationsverstärker (OP) der FET- oder CMOS-Typ ist, der hochohmige Verstärkereingänge aufweist.

2. Phasenregelschaltung nach Anspruch 1, ferner umfassend eine RC-Schaltung (R, C), die vor die Dioden ($D_1$, $D_2$), die mit dem einen Eingang des Operationsverstärkers (OP) verbunden sind, geschaltet ist, um nur Phasen- und Frequenz-Differenzen für Filterungszwecke durchzulassen.

3. Phasenregelschaltung nach Anspruch 1 oder 2, ferner umfassend einen Reihenwiderstand ($R_1$), der mit dem einen Eingang des Operationsverstärkers (OP) für Dimensionierungszwecke verbunden ist.

4. Phasenregelschaltung nach einem der Ansprüche 1 - 3, wobei die Referenzspannung (Ref.) für den Operationsverstärker (OP) so gewählt ist, daß ein Betrieb im wesentlichen in der Mitte eines Pufferspeichers (6) stattfindet.

5. Phasenregelschaltung für eine Jitterverringerung durch Steuern der Ausgangsbitstrom-Frequenz ($D_{out}$) in einem digitalen Multiplexsystem von der Art, die einen Pufferspeicher (6), einen an dem Pufferspeicher (6) ankommenden Bitstrom ($D_{in}$) und einen von dem Puffer weitergeleiteten Ausgangsbitstrom ($D_{out}$) aufweist, wobei der Pufferspeicher (6) Steuersignalausgänge aufweist, auf denen Signale (Pufferposition $D_{in}$, Pufferposition $D_{out}$) erzeugt werden, die die Phase der Impulse in dem ankommenden Bitstrom ($D_{in}$) und die Phase der von dem Pufferspeicher (6) weitergeleiteten Impulse ($D_{out}$) anzeigen, wobei die Phasenregelschaltung umfaßt:

einen Phasenvergleicher (4),

einen spannungsgesteuerten Oszillator (VCO) und

eine Steuerschaltung (2),

wobei der Phasenvergleicher (4) zum Empfang der Steuersignale verschaltet ist, um ein Ausgangssignal zu liefern, das die gegenseitige Phasenposition der Impulse in dem ankommenden und dem weitergeleiteten Bitstrom ($D_{in}$, $D_{out}$) darstellt, wobei das Ausgangssignal an die Steuerschaltung (2) für eine automatische Verstärkungssteuerung geführt wird, die Steuerschaltung (2) die Impulsrate des spannungsgesteuerten Oszillators (VCO) steuert, der Taktimpulse zum Takten der Impulse des weitergeleiteten Bitstroms ($D_{out}$) erzeugt; und

die Steuerschaltung umfaßt:

- einen rückgekoppelten Operationsverstärker (OP), der zwischen den Phasenvergleicher (2) und den spannungsgesteuerten Oszillator (VCO) geschaltet ist, wobei der Operationsverstärker (OP) einen Ausgang und erste und zweite Eingänge aufweist, wobei die Eingänge hochohmig sind, der erste Eingang eine Rückkopplung ($R_2$, $C_2$) von dem Ausgang empfängt und der zweite Eingang mit einer Referenzspannung (Ref.) verbunden ist; und

- zwei Dioden, die zueinander an dem ersten Eingang des Operationsverstärkers (OP) antiparallel geschaltet sind, um die automatische Verstärkungssteuerung zu erzielen.

**6.** Phasenregelschaltung in einem digitalen Multiplexsystem nach Anspruch 5, wobei die Steuerschaltung (2) ferner eine RC-Schaltung (R, C) umfaßt, die mit einem Eingang für die zwei Dioden ($D_1$, $D_2$) zum Durchlassen nur der Phasen- und Frequenz-Differenzen, die von dem Phasenvergleicher (4) erfaßt werden, und für Filterzwecke verbunden ist.

**7.** Phasenregelschaltung in einem digitalen Multiplexsystem nach Anspruch 6, wobei die Steuerschaltung (2) ferner einen weiteren Reihenwiderstand ($R_1$) umfaßt, der zwischen die zwei Dioden ($D_1$, $D_2$) und den ersten Eingang des Operationsverstärkers (OP) für Dimensionierungszwecke geschaltet ist.

**8.** Phasenregelschaltung in einem digitalen Multiplexsystem nach einem der Ansprüche 5 - 7, wobei der Operationsverstärker (OP) in der Steuerschaltung (2) der FET- oder CMOS-Typ mit hochohmigen Verstärkereingängen ist.

**9.** Phasenregelschaltung in einem digitalen Multiplexsystem nach einem der Ansprüche 5 - 8, wobei die Referenzspannung (Ref.) für den Operationsverstärker (OP) sich auf den Betrieb des Pufferspeichers (6) bezieht.

## Revendications

**1.** Circuit d'asservissement de phase pour la réduction de la gigue dans un système de multiplex numérique, le circuit comprenant un amplificateur opérationnel à rétroaction (OP) ayant deux entrées, deux diodes ($D_1$, $D_2$) couplées de façon antiparallèle étant disposées à une première entrée de l'amplificateur opérationnel (OP) pour réaliser une commande automatique de gain, l'autre entrée de l'amplificateur opérationnel étant connectée à une tension de référence (Ref.), l'amplificateur opérationnel (OP) étant du type à transistors à effet de champ ou CMOS, et ayant des entrées d'amplificateur à valeur ohmique élevée.

**2.** Circuit d'asservissement de phase selon la revendication 1, comprenant en outre un circuit RC (R, C) connecté devant les diodes ($D_1$, $D_2$) qui sont connectées à la première entrée de l'amplificateur opérationnel (OP), pour laisser passer seulement des différences de phase et de fréquence, dans un but de filtrage.

**3.** Circuit d'asservissement de phase selon la revendication 1 ou 2, comprenant en outre une résistance série ($R_1$) connectée à la première entrée de l'amplificateur opérationnel (OP) dans un but de dimensionnement.

**4.** Circuit d'asservissement de phase selon l'une quelconque des revendications 1 à 3, dans lequel la tension de référence (Ref.) pour l'amplificateur opérationnel (OP) est sélectionnée de façon que le fonctionnement ait lieu pratiquement au milieu d'une mémoire tampon (6).

**5.** Circuit d'asservissement de phase pour la réduction de la gigue par la commande de la fréquence d'un train de bits de sortie ($D_{out}$) dans un système de multiplex numérique du genre ayant une mémoire tampon (6), un train de bits entrant ($D_{in}$) arrivant à la mémoire tampon (6), et un train de bits de sortie ($D_{out}$) étant émis par la mémoire tampon, la mémoire tampon (6) ayant des sorties de signaux de commande sur lesquelles sont générés des signaux (Buffer position $D_{in}$, Buffer position $D_{out}$) indiquant la phase des impulsions dans le train de bits entrant ($D_{in}$) et la phase des impulsions ($D_{out}$) qui sont émises par la mémoire tampon (6), le circuit d'asservissement de phase comprenant

un comparateur de phase (4),
un oscillateur commandé par tension (VCO) et
un circuit de commande (2),
le comparateur de phase (4) étant connecté de façon à recevoir les signaux de commande pour fournir un signal de sortie représentatif de la position de phase mutuelle des impulsions dans les trains de bits entrant et émis ($D_{in}$, $D_{out}$), le signal de sortie étant appliqué au circuit de commande (2) pour la commande automatique de gain, le circuit de commande (2) commandant la cadence d'impulsions de l'oscillateur commandé par tension (VCO), qui génère des impulsions d'horloge pour synchroniser les impulsions du train de bits émis ($D_{out}$), et le circuit de commande comprenant

- un amplificateur opérationnel (OP) avec rétroaction, connecté entre le comparateur de phase (2) et l'oscillateur commandé par tension (VCO), l'amplificateur opérationnel (OP) ayant une sortie et des première et seconde entrées, les entrées ayant une valeur ohmique élevée, la première entrée recevant une rétroaction ($R_2$, $C_2$) provenant de la sortie et la seconde entrée étant connectée à une tension de référence (Ref.), et
- deux diodes couplées l'une à l'autre de manière antiparallèle à la première entrée de l'amplificateur opérationnel (OP), pour réaliser la commande automatique de gain.

6. Circuit d'asservissement de phase dans un système de multiplex numérique selon la revendication 5, dans lequel le circuit de commande (2) comprend en outre un circuit RC (R, C) connecté à une entrée pour les deux diodes ($D_1$, $D_2$) pour laisser passer seulement des différences de phase et de fréquence qui sont détectées par le comparateur de phase (4), et dans un but de filtrage.

7. Circuit d'asservissement de phase dans un système de multiplex numérique selon la revendication 6, dans lequel le circuit de commande (2) comprend en outre une résistance série ($R_1$) connectée entre les deux diodes ($D_1$, $D_2$) et la première entrée de l'amplificateur opérationnel (OP), dans un but de dimensionnement.

8. Circuit d'asservissement de phase dans un système de multiplex numérique selon l'une quelconque des revendications 5 à 7, dans lequel l'amplificateur opérationnel (OP) dans le circuit de commande (2) est du type à transistors à effet de champ ou CMOS, ayant des entrées d'amplificateur à valeur ohmique élevée.

9. Circuit d'asservissement de phase dans un système de multiplex numérique selon l'une quelconque des revendications 5 à 8, dans lequel la tension de référence (Ref.) pour l'amplificateur opérationnel (OP) est liée au fonctionnement de la mémoire tampon (6).

## Fig. 1

## Fig. 2